# EUROPEAN PATENT APPLICATION

(11) **EP 4 697 188 A1**
(43) Date of publication of application: **18.02.2026**
(21) Application number: 25192270.4
(22) Date of filing: 28.07.2025
(51) Int. Cl.: G06F 13/40, G06F 13/42

(54) **NETWORK IDENTIFICATION USING DIFFERENTIAL VOLTAGES**

(30) Priority: 31.07.2024 US 202463677748 P; 16.07.2025 US 202519271146
(71) Applicant: Vertiv Corporation, Westerville, OH 43082 (US)
(72) Inventor: Peltier, Jason David, Westerville, 43082 (US); Krajewski, Gary Lee, Westerville, 43082 (US)
(74) Representative: Cousens, Nico

(57) **Abstract**

A computer system that allows a central device to transmit identification information to multiple peripheral devices is disclosed. The central device is coupled to multiple peripheral devices via respective point-to-point communication links. The central device may send a first identifier to a particular peripheral device of the multiple peripheral devices using a particular common mode voltage on a particular point-to-point communication link that is coupled between the central device and the particular peripheral device.

## Description

### RELATED APPLICATIONS

This U.S. Non-Provisional Patent Applications claims the benefit of and priority to U.S. Provisional Patent Application Serial No. 63/677,748 filed July 31, 2024.

### FIELD

The described embodiments relate generally to high-speed communication interface design and, more particularly, to techniques for relaying identification information to peripheral devices coupled to a communication interface.

### BACKGROUND

Computing systems typically include a number of interconnected integrated circuits. The integrated circuits may be mounted on different circuit boards. In some cases, the integrated circuit may communication using communication channels or links to transmit and receive data symbols or bits. The communication channels may support parallel communication, in which multiple data bits are transmitted in parallel, or serial communication in which data bits are transmitted one bit a time in a serial fashion.

In some systems, communication links that are connected to multiple devices may be employed to reduce wiring overhead. Such communication links may be referred to as "multi-drop communication links" and may support either parallel or serial communication. In such communication links, messages and responses transmitted via the communication link may be encoded with identification information to allow the multiple devices to identify the target recipient.

### SUMMARY

Various embodiments of a computer system are disclosed. Broadly speaking, a computer system includes a central device coupled to a plurality of peripheral devices via respective ones of a plurality of point-to-point communication links. The central device may be configured to send a first identifier to a first peripheral device of the plurality of peripheral devices using a first common mode voltage on a first point-to-point communication link of the plurality of point-to-point communication links, where the first point-to-point communication link is coupled between the first peripheral device and the central device. The central device may also be configured to send a second identifier to a second peripheral device of the plurality of peripheral devices using a second common mode voltage on a second point-to-point communication link of the plurality of point-to-point communication links, where the second point-to-point communication link is coupled between the second peripheral device and the central device.

### BRIEF DESCRIPTION OF THE DRAWINGS

FIG. 1 is a block diagram depicting an embodiment of a computer system.
FIG. 2 is a diagram depicting a mapping between different voltage ranges and different identifiers.
FIG. 3 is a block diagram depicting an embodiment of a central device.
FIG. 4 is a block diagram depicting an embodiment of a peripheral device.
FIG. 5 is a flow diagram depicting an embodiment of a method for transmitting identification information via a communication link.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

It may be understood that the example embodiments described herein may be considered in a descriptive sense only and not for purposes of limitation. Descriptions of features or aspects within each example embodiment may be considered as available for other similar features or aspects in other example embodiments.

In some computer systems, multiple devices can communicate with each other using multi-drop communication links in which all of the devices send and receive messages from a common bus. For such communication to function properly, identifying information (referred to as "identifiers") are included in messages to allow for the identification of sender and receiver. The identifiers are unique and correspond to different devices coupled to the multi-drop communication link.

In some computer systems, individual devices are preprogrammed with their corresponding identifiers. Hardware jumpers or switches on the devices can be used to program each device with a unique identifier. Such hardware jumpers and switches can contribute to added manufacturing costs and complexity.

In other computer systems, a central or leader device coupled to multi-drop communication link may program other peripheral devices with unique identifiers before the multi-drop communication link can be used. Such programming may be performed in response to a power-up or boot operation of a computer system. Since the multi-drop communication link needs the identifiers to send and receive messages, other dedicated point-to-point wires are employed that allow the leader device to send identifiers to each peripheral device on the multi-drop communication link. Such point-to-point wires can increase cost and complexity of a computer system.

The embodiments illustrated in the drawings and described below provide techniques for using common mode operating voltages of differential signals to program identifiers for devices using a multi-drop communication link. By using such common mode voltages, the expense and overhead associated with the use of hardware jumpers or switches on the device, or dedicated wires for programming identifiers from a central device can be eliminated.

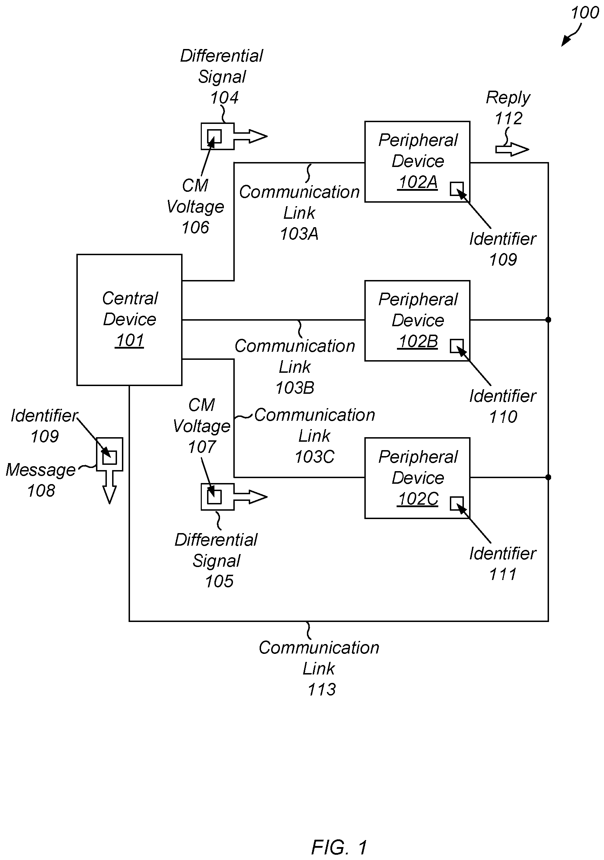

A block diagram of a computer system with multiple communication links is depicted in FIG. 1. In various embodiments, computer system 100 may be used in a variety of applications. For example, computer system 100 may be used in consumer electronics, household appliances, vehicles including aircraft, automobiles, etc., or any other suitable application.

As illustrated, computer system 100 includes central device 101 and peripheral devices 102A-102C. Although only three peripheral devices are depicted in the embodiment of FIG. 1, in other embodiments, any suitable number of peripheral devices may be employed. In various embodiments, peripheral devices may be configured to sense environmental conditions, sense operating parameters of equipment, e.g., motors, servos, etc., connected to computer system 100, control the equipment connected to computer system 100, etc.

Central device 101 is coupled to peripheral device 102A via communication link 103A. In a similar fashion, central device 101 is coupled to peripheral devices 102B and 102C via communication links 103B and 103C, respectively. In various embodiments, communication links 103A-103C may be implemented using corresponding RS-495 transmission lines or any other suitable type of transmission lines. Communication links 103A-103C are configured to support serial communication using differential signals whose common mode voltages can vary over a range of voltage levels.

Central device 101 is also coupled to peripheral devices 102A-102C via communication link 113. In various embodiments, communication link 113 may be implemented as a multi-drop communication link where each of central device 101 and peripheral devices 102A-102C have unique identifiers that can be used to identify a message sender, a message destination, and the like. In some cases, communication link 113 may be implemented using a controller area network (or "CAN") bus.

In various embodiments, central device 101 is configured to send the unique identifiers to peripheral devices 102A-102C. In some cases, central device 101 may be configured to send the identifiers to peripheral devices 102A-102C in response to a detection of a reset condition, e.g., receiving a reset signal. In some embodiments, the reset condition may correspond to a power-up or boot of computer system 100.

Central device 101 is configured to send identifier 109 to peripheral device 102A using common mode voltage 106 (denoted "CM voltage" 106) for differential signal 104 on communication link 103A. In various embodiments, central device 101 is configured to send identifier 111 to peripheral device 102C using common mode voltage 107 (denoted as "CM voltage 107") of differential signal 105 on communication link 103C. By sending identifier 109 and 111 using respective common mode voltages of communication links 103A and 103B, problematic hardware programming or the cost associate with additional wiring can be avoided.

In different embodiments, central device 101 is also configured to broadcast message 108 via communication link 113. As illustrated, message 108 includes identifier 109 which specifies the destination of message 108 as peripheral device 102A since it has been programmed with identifier 109. In various embodiments, peripheral device 102A receive message 108 via communication link 113. In response to a determination that message 108 includes identifier 109, peripheral device 102 is further configured to send reply 112 via communication link 113.

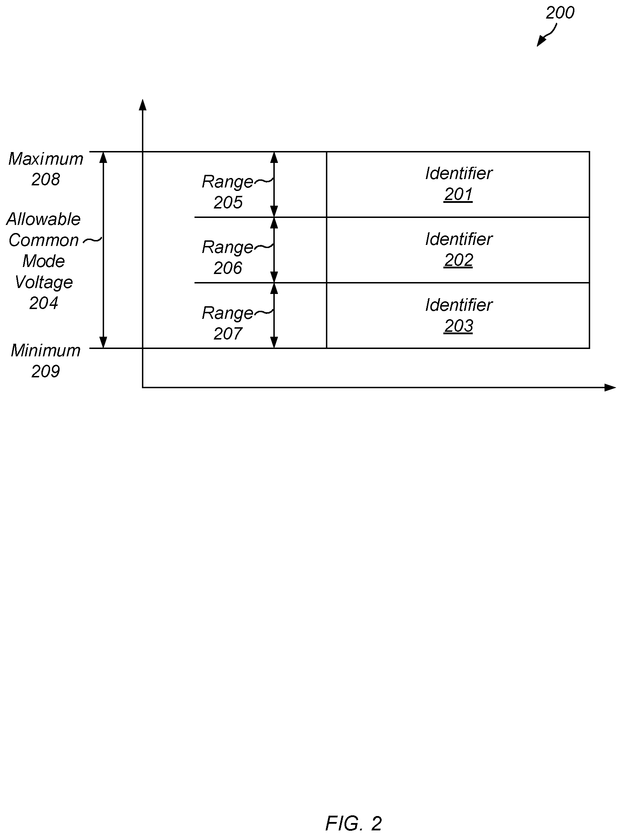

Turning to FIG. 2, a diagram illustrating a mapping between different voltage ranges and different identifiers is depicted. As illustrated, allowable common mode voltage 204 corresponds range of common mode voltages that are allowable on communication links 103A-103C, which can vary between minimum 209 and maximum 208. For example, in some cases, allowable common mode voltage 204 may be between -7 volts and +12 volts.

The voltage range between minimum 209 and maximum 208 is divided into ranges 205-207. Although only three ranges are shown, in other embodiments, any suitable number of ranges may be employed. In some embodiments, the number of ranges employed may correspond to a number of peripheral devices coupled to central device 101. It is noted that although respective sizes of ranges 205-207 are depicted as being equal, in other embodiments, the sizes of ranges 205-207 may not be equal provided that the sum of the sizes of ranges 205-207 does not exceed the entirety of allowable common mode voltage 204.

Each of ranges 205-207 correspond to a different identifier value. As illustrated, range 205 corresponds to identifier 201, while ranges 206 and 207 correspond to identifiers 202 and 203, respectively. In various embodiments, identifiers 201-203 may correspond to identifiers 109-111 respectively.

As described below, when the common mode voltage of a given one of communication links 103A-103C is measured by a corresponding one of peripheral devices 102A-102C, the measure common mode voltage is compared to ranges 205-207. Based on a result of the comparison the corresponding one of peripheral devices 102A-102C sets its identifier to the identifier corresponding to given one of ranges 205-207 that includes the measured common mode voltage. For example, if the measured common mode voltage is in range 206, then identifier 202 will be selected.

In various embodiments, identifiers 201-203 may include a number of bits whose value corresponds to a particular numbers. For example, identifiers 201-203 may each includes 2-bits, where the value of the bits included in 201 correspond to the number 1, while the values of the respective bits for identifiers 202 and 203 correspond to the numbers 2 and 3, respectively.

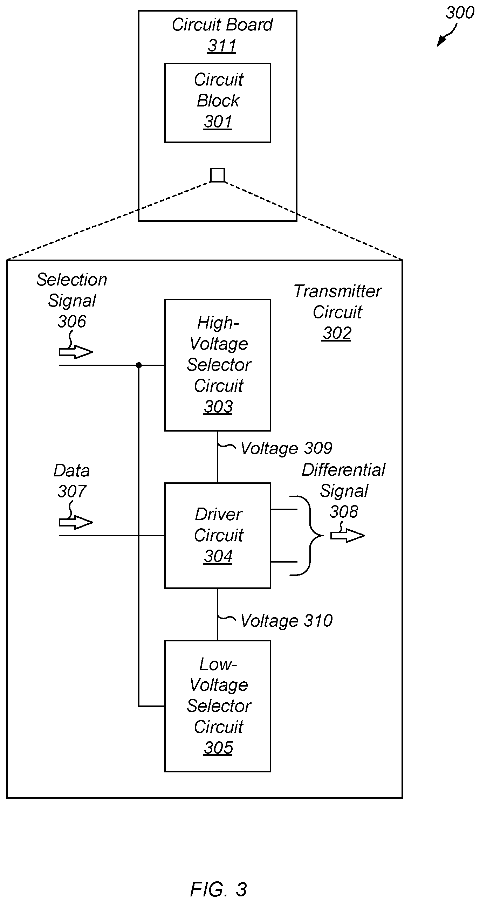

A block diagram of a central or leader device is depicted in FIG. 3. As illustrated, central device 300 includes circuit board 311, which includes circuit block 301 and transmitter circuit 302, which includes high-voltage selector circuit 303, driver circuit 304, and low-voltage selector circuit 305. In various embodiments, central device 300 may correspond to central device 101 as depicted in FIG. 1.

Circuit block 301 may include any suitable circuit elements including integrated circuits, discrete active circuit components (e.g., diodes, transistors, etc.), discrete passive circuit components (e.g., resistors, inductor, capacitors, etc.), and the like. Although circuit board 311 is depicted as including only a single circuit block, in other embodiments, any suitable number of circuit blocks may be employed.

Transmitter circuit 302 includes high-voltage selector circuit 303, driver circuit 304, and low-voltage selector circuit 305. In various embodiments, high-voltage selector circuit 303 is configured to supply voltage 309 to driver circuit 304 based on selection signal 306. In a similar fashion, low-voltage selector circuit 305 is configured to supply voltage 310 to driver circuit 304. In various embodiments, high-voltage selector circuit 303 and low-voltage selector circuit 305 may be implemented using variable voltage sources, multiple voltage sources with analog multiplex circuits, or any other suitable circuit configured to provide discrete voltage values based on selection signal 306.

Driver circuit 304 is configured to generate differential signal 308 on one of communication links 103A-103C using data 307 and voltages 309 and 310. To generate signal 308, driver circuit may change the respective voltage levels of the two signals included in differential signal 308 between voltage 309 and voltage 310 based on data 307. The difference between voltage 309 and voltage 310 sets the common mode voltage for differential signal 308. As described above, the common mode voltage of differential signal 308 may be used to convey identifier information to a peripheral device.

In various embodiments, selection signal 306 may be based on a desired value for an identifier to be transmitted via differential signal 308. For example, selection signal 306 may be set to a particular value in order to cause differential signal 308 to have a common mode voltage in range 206 in order to convey identifier 202. It is noted that, in some embodiments, once a programming operation has been completed, selection signal 306 may be adjusted such that high-voltage selector circuit 303 and low-voltage selector circuit 305 provide voltages 309 and 310, respectively, such that power dissipation to generate differential signal 308 is minimized.

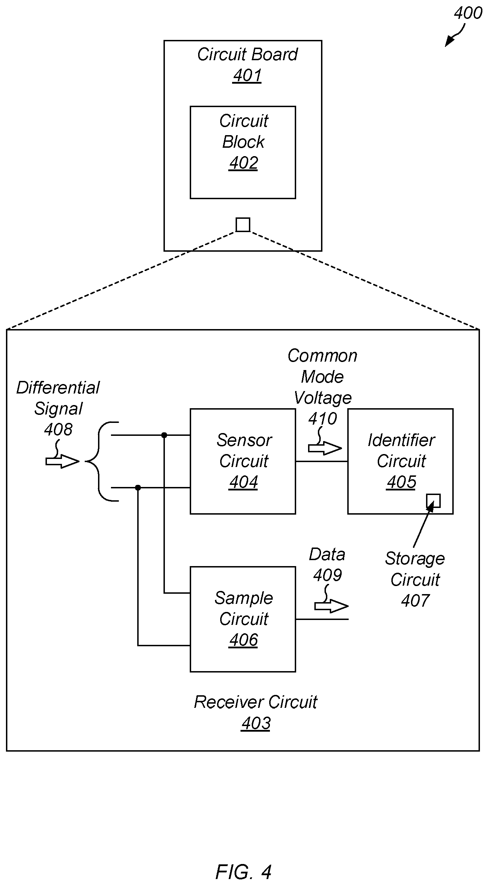

Turning to FIG. 4, a block diagram of an embodiment of a peripheral device is depicted. As illustrated peripheral device 400 includes circuit board 401, which includes circuit block 402 and receiver circuit 403, which includes sensor circuit 404, identifier circuit 405, comparator circuit 406, and storage circuit 407. In various embodiments, peripheral device 400 may correspond to any of peripheral devices 102A-102C as depicted in FIG. 1.

In various embodiments, circuit block 402 may include any suitable combination of integrated circuits, discrete active circuit components, discrete passive circuit components, and the like. Although circuit board 401 is depicted as including a single circuit block, in other embodiments, circuit board 401 may include any suitable number of circuit blocks.

Sample circuit 406 is configured to generate data 409 using differential signal 408. In various embodiments, differential signal 408 may be received via one of communication links 103A-103C. To generate data 409, sample circuit 406 may be configured to determine which of the two signals included in differential signal 408 has a greater voltage level. Individual bits of data 409 may correspond to which of the two signals has the greater voltage. For example, if a first signal of differential signal 408 is greater than a second signal of differential signals 408, differential signal 408 may be encoding a logical-0. In various embodiments, a clock-recovery circuit (not shown) may be employed to recover clock information from differential signal 408. The recovered clock information may be used by sample circuit 406 to sample differential signal 408 at specific times.

Sensor circuit 404 is configured to generate common mode voltage 410 using differential signal 408. To generate common mode voltage 410, sensor circuit 404 may be configured to determine a difference in the voltage levels between the two signals included in differential signal 408 at particular points in time. The resultant difference in the voltage levels can be used to determine common mode voltage 410.

Identifier circuit 405 is configured to determine an identifier, e.g., identifier 109, by using common mode voltage 410. Once the identifier has been determined, it may be stored in storage circuit 407 which may be implemented as a register file circuit. To determine the identifier, identifier circuit 405 may configured to compare common mode voltage 410 to a plurality of ranges, e.g., ranges 205-207 as depicted in FIG. 2. In some embodiments, the comparison may be performed using analog circuit while, in other embodiments, common mode voltage 410 may be converted to a digital word using an analog-to-digital converter circuit and the comparison to the different ranges can be performed in the digital domain. It is noted that in some embodiments, sensor circuit 404 may only be active during a program operation. Such an operation may be triggered as part of a reset or boot operation, or may be trigger by a specific sequence of bits encoded in differential signal 408.

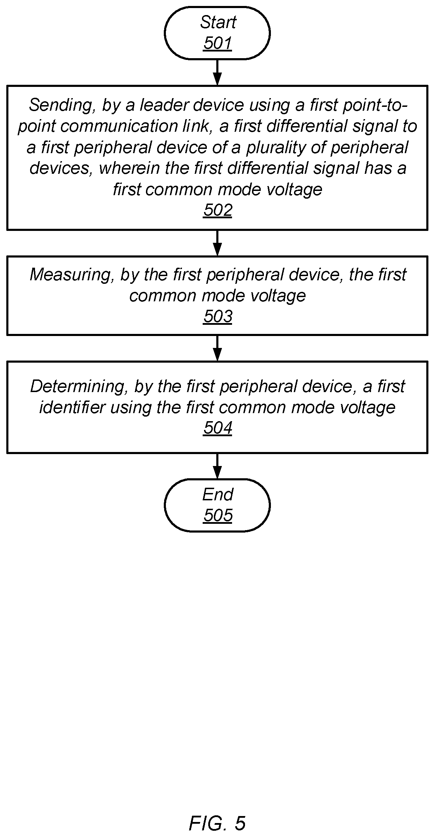

Turning to FIG. 5, a flow diagram of an embodiment of a method for transmitting identification information via a communication link is depicted. The method, which may be applied to various communication links such as those depicted in FIG. 1, begins in block 501.

The method includes sending, by a leader device using a first point-to-point communication link, a first differential signal to a first peripheral device of a plurality of peripheral devices (block 502). In various embodiments, the first differential signal has a first common mode voltage. In some cases, the method also includes sending, by the leader device using a second point-to-point communication link, a second differential signal, with a second common mode voltage, to a second peripheral device of the plurality of peripheral devices. In some embodiments, the method includes sending, by the leader device in response to detecting a reset operation, the first differential signal to the first peripheral device.

The method further includes measuring, by the first peripheral device, the first common mode voltage (block 503). In some cases, the method also includes measuring, by the second peripheral device, the second common mode voltage.

The method also includes determining, by the first peripheral device, a first identifier using the first common mode voltage (block 504). In other embodiments, the method further includes determining, by the second peripheral device, a second identifier using the second common mode voltage. In some embodiments, the method includes storing, by the first peripheral device, the first identifier in a storage circuit included in the first peripheral device.

In some embodiments, determining, by the first peripheral device, the first identifier, includes comparing, by the first peripheral device, the first common mode voltage to a plurality of voltage ranges. The method may additionally include selecting, by the first peripheral device, the first identifier from a plurality of identifiers in response to determining the first common mode voltage is within a particular voltage range of the plurality of voltage ranges, where the particular voltage range corresponds to the first identifier.

In various embodiments, the method further includes broadcasting, by the leader device via a multi-drop communication link, a first message that includes the first identifier, where the multi-drop communication link is coupled to the plurality of devices. In such cases, the method also includes replying, by the first peripheral device via the multi-drop communication link, to the first message in response to determining the first message includes the first identifier. In some embodiments, multi-drop communication link includes a controller area network bus. The method concludes in block 505.

## Claims

1. An apparatus, comprising:
a plurality of peripheral devices (102A, 102B, 102C); and
a central device (101) coupled to the plurality of peripheral devices via respective ones of a plurality of point-to-point communication links (103A, 103B, 103C), wherein the central device is configured to:
send a first identifier (109) to a first peripheral device (102A) of the plurality of peripheral devices using a first common mode voltage (106) on a first point-to-point communication link (103A) of the plurality of point-to-point communication links, wherein the first point-to-point communication link is coupled between the first peripheral device and the central device; and
send a second identifier (110) to a second peripheral device (102B) of the plurality of peripheral devices using a second common mode voltage (107) on a second point-to-point communication link (103B) of the plurality of point-to-point communication links, wherein the second point-to-point communication link is coupled between the second peripheral device and the central device.

2. The apparatus of claim 1, wherein the central device is further coupled the plurality of peripheral devices via a multi-drop communication link, and wherein the central device is further configured to broadcast, via the multi-drop communication link, a first message that includes the first identifier, and wherein the first peripheral device is configured to:
receive the first message via the multi-drop communication link; and
respond, via the multi-drop communication link, to the first message in response to a determination that the first message includes the first identifier,
optionally where the multi-drop communication link includes a controller area network bus.

3. The apparatus of any preceding claim, wherein the first peripheral device is further configured to:
measure the first common mode voltage of the first point-to-point communication link;
determine a value for the first identifier using the first common mode voltage; and
store the value for the first identifier in a storage device included in the first peripheral device.

4. The apparatus of claim 3, wherein to determine the value for the first identifier, the first peripheral device is further configured to:
compare the first common mode voltage to a plurality of voltage ranges; and
select the value for the first identifier from a plurality of values in response to a determination that the first common mode voltage is within a particular voltage range of the plurality of voltage ranges, wherein the particular voltage range corresponds to the value for the first identifier.

5. The apparatus of any preceding claim, wherein the central device and the plurality of peripheral devices are mounted on corresponding circuit boards of a plurality of circuit boards.

6. A method, comprising:
sending, by a leader device using a first point-to-point communication link (103A), a first differential signal (105) to a first peripheral device (102A) of a plurality of peripheral devices (102A, 102B, 102C), wherein the first differential signal has a first common mode voltage (106);
measuring, by the first peripheral device (102A), the first common mode voltage; and
determining, by the first peripheral device, a first identifier (109) using the first common mode voltage.

7. The method of claim 6, further comprising:
sending, by the leader device using a second point-to-point communication link, a second differential signal to a second peripheral device of the plurality of peripheral devices, wherein the second differential signal has a second common mode voltage;
measuring, by the second peripheral device, the second common mode voltage; and
determining, by the second peripheral device, a second identifier using the second common mode voltage.

8. The method of claim 6 or 7, further comprising:
broadcasting, by the leader device via a multi-drop communication link, a first message that includes the first identifier, wherein the multi-drop communication link is coupled to the plurality of peripheral devices; and
replying, by the first peripheral device via the multi-drop communication link, to the first message in response to determining the first message includes the first identifier,
optionally wherein the multi-drop communication link includes a controller area network bus.

9. The method of any of claims 6 to 8, wherein determining, by the first peripheral device, the first identifier includes:
comparing, by the first peripheral device, the first common mode voltage to a plurality of voltage ranges; and
selecting, by the first peripheral device, the first identifier from a plurality of identifiers in response to determining the first common mode voltage is within a particular voltage range of the plurality of voltage ranges, wherein the particular voltage range corresponds to the first identifier,
and optionally further comprising storing, by the first peripheral device, the first identifier in a storage circuit included in the first peripheral device.

10. The method of any of claims 6 to 9, further comprising sending, by the leader device in response to detecting a reset operation, the first differential signal to the first peripheral device.

11. A system, comprising:
a plurality of peripheral circuit boards; and
a leader circuit board coupled to the plurality of peripheral circuit boards by respective ones of a plurality of point-to-point communication links, wherein the leader circuit board is configured to send a particular differential signal with a particular common mode voltage to a particular peripheral circuit board of the plurality of peripheral circuit boards using a particular point-to-point communication link of the plurality of point-to-point communication links; and
wherein the particular peripheral circuit board is configured to:
measure the particular common mode voltage on the particular point-to-point communication link; and
determine a particular identifier using the particular common mode voltage.

12. The system of claim 11, wherein the leader circuit board is further configured to send a different differential signal with a different common mode voltage to a different peripheral circuit board of the plurality of peripheral circuit boards using a different point-to-point communication link of the plurality of point-to-point communication links, and wherein the different peripheral circuit board is configured to:
measure the different common mode voltage on the different point-to-point communication link; and
determine a different identifier using the different common mode voltage.

13. The system of claim 11 or 12, wherein the leader circuit board is further coupled to the plurality of peripheral circuit boards via a multi-drop communication link, and wherein the leader circuit board is further configured to broadcast a first message that includes the particular identifier, wherein the multi-drop communication link is coupled to the plurality of peripheral circuit boards, and wherein the particular peripheral circuit board is further configured, in response to a determination that the first message includes the particular identifier, reply to the leader circuit board via the multi-drop communication link,
and optionally wherein the multi-drop communication link includes a controller area network bus.

14. The system of any of claims 11 to 13, wherein to determine the particular identifier the particular peripheral circuit board is further configured to:
compare the particular common mode voltage to a plurality of voltage ranges; and
select the particular identifier from a plurality of identifiers in response to a determination that the particular common mode voltage is within a particular voltage range of the plurality of voltage ranges, wherein the particular voltage range corresponds to the particular identifier.

15. The system of any of claims 11 to 14, wherein the particular peripheral circuit board is further configured to store the particular identifier in a storage circuit included in the particular peripheral circuit board and/or wherein the leader circuit board is further configured, in response to a detection of a reset operation, to send the particular differential signal to the particular peripheral circuit board.
